# FASCICULE DE BREVET EUROPEEN

(11) **EP 1 104 229 B1**
(45) Date de publication et mention de la délivrance du brevet: **13.03.2002**
(21) Numéro de dépôt: 00403020.1
(22) Date de dépôt: 30.10.2000
(51) Int. Cl.: H05K 7/00, H05K 1/00, H05K 7/14

(54) **Dispositif de fixation d'une carte électronique dans un boîter et procédé de fixation**
Befestigungsvorrichtung für eine Leiterplatte in einem Gehäuse und Befestigungsverfahren
Fastening device for a pcb in a casing and fastening method

(30) Priorité: 25.11.1999 FR 9914854
(43) Date de publication de la demande: 30.05.2001
(73) Titulaire: SAGEM S.A., 75015 Paris (FR)
(72) Inventeur: Poggi, Philippe, 75016 Paris (FR)
(74) Mandataire: Schmit, Christian Norbert Marie

(56) Documents cités:
- DE-U- 8 813 457
- DE-U- 29 607 138
- DE-U- 29 720 772
- DE-U- 29 807 427

## Description

La présente invention a pour objet un boîtier avec un dispositif de fixation d'une carte électronique. Elle a également pour objet un procédé de fixation d'une telle carte électronique dans un tel boîtier. Elle trouve plus particulièrement son utilisation dans le domaine des boîtiers électroniques, notamment des télévisions, des décodeurs et plus généralement des appareils électroniques grand public. Dans l'état de la technique, on connaît principalement des cartes électroniques vissées dans ces boîtiers. L'intérêt de l'invention est qu'elle propose un moyen de fixation de ces cartes électroniques ne nécessitant pas de vis.

Dans l'état de la technique, on connaît principalement un boîtier, comportant une carte électronique vissée dans le boîtier. Dans un tel boîtier, un fond de ce boîtier comporte des emplacements, par exemple des orifices, pour y visser des entretoises. Ces entretoises sont dans un exemple de même hauteur. Généralement, pour fixer une carte électronique dans un tel boîtier, on monte quatre entretoises dans le boîtier. Préférentiellement, ces quatre entretoises sont disposées au niveau de quatre coins de la plaque électronique, qui est généralement de forme rectangulaire. Ensuite, pour retenir la plaque électronique dans le boîtier, il est nécessaire de visser la carte électronique à chacune des entretoises. Pour cela, la carte électronique comporte quatre orifices pour permettre à des vis de traverser la carte électronique, et ensuite d'être vissée dans ces entretoises. Par ailleurs, quand il est nécessaire d'empiler plusieurs cartes de circuits imprimés à l'intérieur de ce boîtier, on dispose de nouvelles entretoises sur une carte déjà montée dans le boîtier de manière à pourvoir fixer sur ce nouveau jeu d'entretoises une deuxième carte électronique. Pour assurer une fixation solide de ces cartes de circuit imprimé par l'intermédiaire d'entretoises, étant donné la longueur des vis, une distance entre deux circuits imprimés superposés, ou entre un circuit imprimé et le fond du boîtier, est d'au moins un centimètre.

Les moyens de fixation d'une carte électronique dans un boîtier de l'état de la technique posent un problème. En effet, ils nécessitent la mise en oeuvre de nombreuses vis pour assurer une bonne fixation de ces cartes électroniques à l'intérieur du boîtier. Ces vis posent un problème majeur du fait que ce sont de petites pièces à monter de manière individuelle et également minutieusement dans le boîtier. L'étape de vissage ne permet pas un montage rapide de ces cartes électroniques à l'intérieur du boîtier. Or dans l'état de la technique, il est nécessaire de pouvoir réaliser ce montage rapidement étant donné des cadences élevées des productions auxquelles sont soumises les lignes de production de téléviseurs, de décodeurs, et/ou d'appareils électroniques en général.

Par ailleurs cette utilisation de vis nécessite la présence d'orifices sur les cartes électroniques. Or une carte de circuit imprimé est généralement prévue et conçue de manière optimale. En effet les pistes présentées sur cette carte de circuit imprimé sont réparties de manière à minimiser la taille globale de la carte. Or s'il est nécessaire de présenter des orifices, on doit agrandir nécessairement la taille de la carte.

Un deuxième inconvénient découlant de l'utilisation de vis est que ces vis sont généralement métalliques. Or lorsqu'on connecte des circuits imprimés à un boîtier, il est nécessaire de faire attention de ne pas court-circuiter les pistes du circuit imprimé par l'intermédiaire des vis avec le boîtier ou éventuellement avec des pistes d'un autre circuit imprimé superposé par un jeu d'entretoises.

De plus, une distance minimale imposée par l'utilisation de vis de un centimètre entre deux cartes électroniques superposées est trop important dans la mesure où généralement on cherche à miniaturiser les dispositifs électroniques dans des boîtiers tels que des téléviseurs ou des appareils électroniques grand public.

L'invention a pour objet de remédier aux problèmes cités en proposant un boîtier avec un dispositif de maintien d'une carte électronique ne nécessitant aucune vis. La solution apportée par l'invention consiste à proposer de retenir d'une part la carte électronique sur un premier côté par un moyen de rétention du boîtier et de la retenir sur un deuxième côté par un verrou élastique. Pour cela, le boîtier comporte une pièce pour présenter un verrou élastique de manière à retenir une carte électronique présentée parallèlement à un fond du boîtier. Cette pièce peut préférentiellement être amovible, et indépendante de la structure du boîtier, Dans un exemple, le moyen de rétention du premier côté de la carte électronique peut être présenté par une paroi perpendiculaire à ce fond du boîtier, tel que le moyen de rétention présenté est disposé à une hauteur équivalante à une hauteur du verrou élastique, ces hauteurs étant définies par rapport au fond du boîtier. La pièce présentant le verrou élastique est montée de manière mécanique, sans nécessiter l'utilisation de vis. Par ailleurs l'utilisation d'un verrou élastique avec effet de clip permet un montage et un démontage rapide d'une carte électronique dans un tel boîtier. Par ailleurs l'utilisation d'un tel clip présente l'avantage majeur que la carte électronique ne nécessite pas la présence d'orifices pour être fixée au boîtier. Donc, on peut ainsi réduire très légèrement la taille de la carte de circuit imprimé, car le verrou élastique ne vient s'appuyer que sur une bordure de ce circuit imprimé. Par ailleurs, on peut facilement empiler différentes cartes de circuit imprimé avec un espacement faible entre ces cartes, en utilisant plusieurs verrous élastiques juxtaposés, et proposant de retenir les cartes électroniques à des hauteurs distinctes mais proches.

L'invention concerne donc un boîtier avec un dispositif de fixation d'une carte électronique, le boîtier comportant un moyen de fixation pour retenir un premier bord de la carte, caractérisé en ce qu'il comporte une pièce munie d'un verrou élastique pour retenir un deuxième bord de la carte.

L'invention concerne également un procédé de fixation d'une carte électronique dans un boîtier caractérisé en ce qu'il comporte les étapes suivantes :
- on insère de manière oblique un premier bord de la carte dans un moyen de maintien du boîtier ;
- on abaisse un deuxième bord de la carte ;
- on écarte légèrement un verrou élastique présenté sur une lame d'une pièce montée dans le boîtier ;
- on relâche le verrou élastique de manière à retenir le deuxième bord de la carte.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :
- Figure 1 : un dispositif de fixation d'une carte électronique dans un boîtier selon l'invention ;
- Figure 2 : une vue d'une pièce permettant la fixation de la carte électronique dans un boîtier selon l'invention ;
- Figure 3 : une vue de dessus d'une pièce permettant la fixation d'une carte électronique dans un boîtier selon l'invention ;
- Figure 4 : une vue de dessus de la pièce permettant la fixation d'une carte électronique dans un boîtier selon l'invention ;
- Figure 5 : une vue en coupe d'un schéma du procédé de fixation selon l'invention.

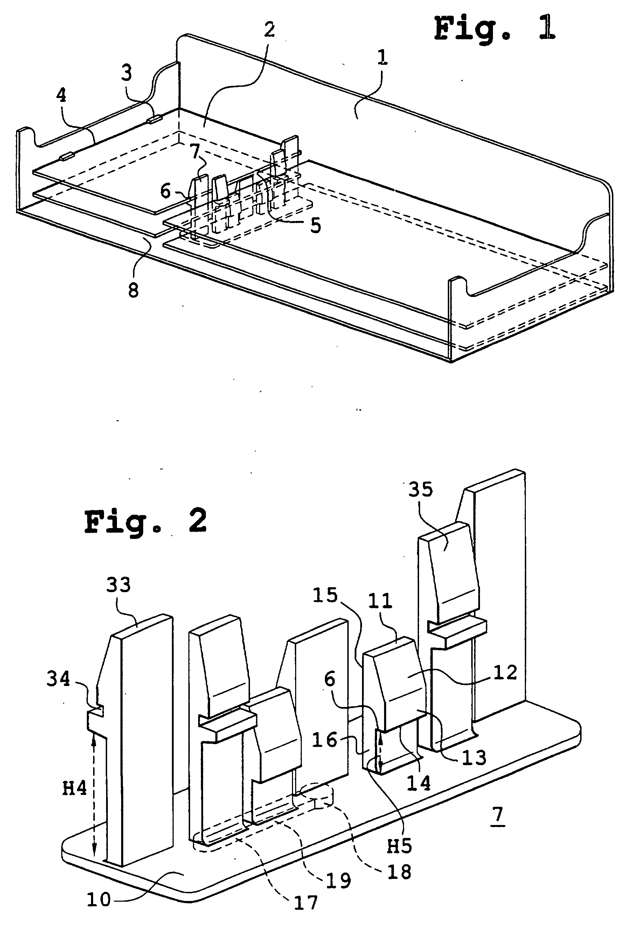

La figure 1 montre un boîtier 1 avec un dispositif de fixation selon l'invention muni d'une carte électronique 2 retenue dans le boîtier 1 par l'intermédiaire d'un premier moyen de fixation 3. En effet, le moyen de fixation 3 retient un premier bord 4 de la carte 2. Un deuxième bord 5 est retenu par un verrou élastique 6 présenté sur une pièce 7 du dispositif. Dans l'exemple présenté figure 1, la carte 2 est préférentiellement disposée parallèlement à un fond 8 du boîtier 1. La carte 2 est une carte électronique comportant des composants discrets reliés entré eux par des connexions réalisées dans la carte. La carte peut être de type multicouches ou bicouches et être alors réalisée a partir d'un circuit imprimé. La carte a une dimension quelconque mais en particulier de l'ordre de 10cmX10cm à 20cmX30cm sans nécessairement être carrée ni même rectangulaire.

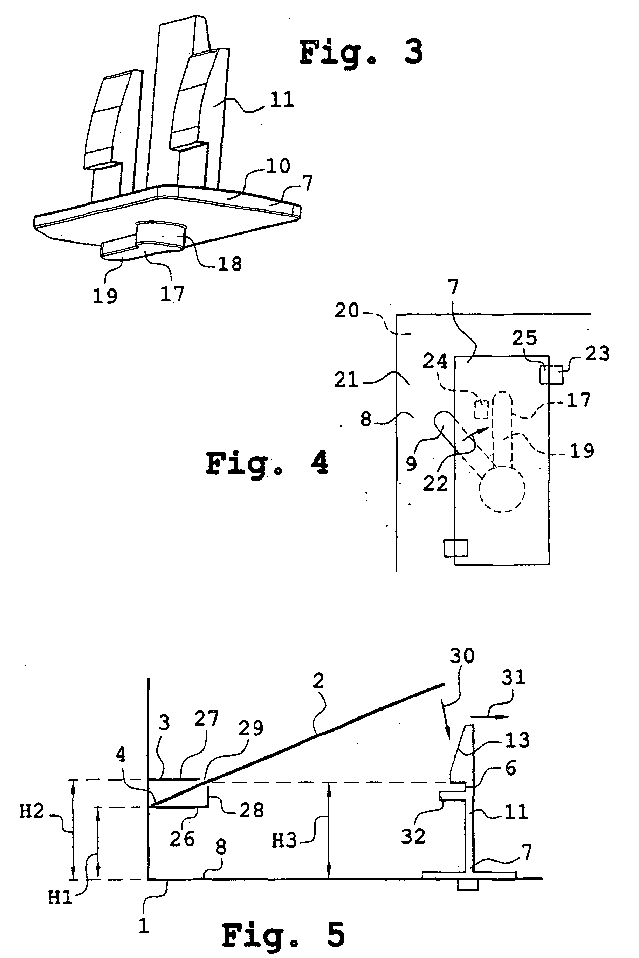

Dans l'exemple présenté figure 1, le boîtier 1 est préférentiellement un boîtier parallélépipédique ouvert sur au moins deux côtés. Ce boîtier peut par exemple être métallique et être celui d'un décodeur de télévision. Le fond 8 est dans cet exemple grillagé de manière à permettre une aération du contenu du boîtier 1. Le fond 8 comporte une ouverture 9, présentée figure 4, pour retenir la pièce 7. La pièce 7, figure 2, comporte principalement un support 10 servant de socle et une lame 11. La lame 11 est représentée dressée de manière perpendiculaire par rapport à un plan formé par le support 10.

La lame 11 présente le verrou élastique 6 sur une face 12 de la lame 11. En effet, sur la face 12, la lame 11 présente un bombement 13 situé dans une partie supérieure de la lame 11, et un décrochement 14 situé dans une partie inférieure de la lame 11. La partie inférieure est comprise entre le bombement 13 et le support 10. La lame 11 est légèrement flexible sur le support 10. En effet, elle peut être courbée légèrement par rapport à un plan formé par la lame 11 en l'absence de contraintes. Cette légère courbure est de l'ordre de 5 à 10 degrés. Cette courbure peut par exemple être générée par l'appui d'une plaque électronique 2 sur le bombement 13. Par ailleurs, le bombement 13 est chanfreiné de manière à ce que la fixation de la carte électronique 2 dans le boîtier 1 se fasse en contraignant la carte 2 contre le bombement 13 de manière à courber la lame 11 légèrement du côté d'une face 15 opposée à la face 12. De plus, pour être assez facilement courbée, la lame 11 comporte un pied 16 de fixation au socle 10 de faible épaisseur.

Pour monter la pièce 7 dans le boîtier 1, on dispose une patte 17, présentée figure 3, en vis-à-vis de l'ouverture 9 du fond 8 du boîtier 1. Pour garantir un placement correct de la pièce 7 sur le fond 8, la forme de l'ouverture 9 est particulière et ne permet une insertion de la patte 17 dans cette ouverture 9 que dans un seul sens, et d'une seule manière. Dans un exemple présenté figure 4, l'ouverture 9 a une forme de cercle muni d'une excroissance allongée en forme de bras. Ainsi, la patte 17 présentée figure 3 comporte préférentiellement un pignon 18 de forme cylindrique pour être attaché au support 10, et un pied 19 ayant une forme allongée. Le pied 19 a une forme d'excroissance allongée en forme de bras complémentaire de l'ouverture 9. Le pignon 18 est fixé au support 10. Le pied 19 est fixé au pignon 18 mais n'est pas fixé directement au support 10.

Le pied 19 étant indépendant du support 10, il est possible après avoir enfoncé complètement le support 10 contre le fond 8 et la patte 19 dans l'ouverture 9, de faire tourner la pièce 7. En effet, le pied 19 peut coulisser sous le fond 8. Le pied 19 coulisse le long d'une face inférieure 20 du fond 8, alors que le support 10 coulisse parallèlement à une face supérieure 21 de ce fond 8. La rotation de la pièce 7 s'effectue selon un sens 22 présenté figure 3. Cette rotation 22 est limitée par la présence d'un décrochement en surélévation 23 présenté du côté de la face supérieure 21 pour venir bloquer le support 10. Dans un exemple préféré de l'invention, la face supérieure 21 présente deux décrochement en surélévation tels que 23. Ces deux décrochements sont alors diamétralement opposés. Les décrochements sont réalisés par estampage et déplacement de matière du fond 8.

Par ailleurs une rotation arrière, selon une direction opposée au sens de rotation 22 peut être rendue impossible, lorsque le support 10 est venu en butée contre le décrochement en surélévation 23, car le pied 19 de la patte 17 est alors retenu par une butée 24 présentée du côté de la face inférieure 20 du fond 8. Cette butée 24 a préférentiellement une forme chanfreinée suivie d'un front anti-retour. En effet, elle peut présenter une pente douce permettant le passage du pied 19 lorsque la rotation est selon le sens 22. Mais elle présente également un rebord franc pour empêcher le retour du pied 19 par une rotation opposée à la rotation 22. La butée 24 est également obtenue par estampage, mais dans une direction différentes de la direction des décrochement 23. Le pied 19 coopère avec la butée 24 en même temps que le support 10 coopère avec le décrochement en surélévation 23 pour empêcher ensuite une rotation de ce support 10 dans l'un quelconque des sens de la pièce 7.

Par ailleurs le décrochement en surélévation 23 comporte une griffe 25 qui vient recouvrir une portion du support 10. Ainsi la griffe 25 empêche un arrachage de la pièce 10 du fond 8. En effet, le seul pied 19 ne peut suffire à retenir la pièce 7 sur le fond 8 étant donné que le pied 19 est fin, flexible et donc fragile. Ainsi bloqué, le support est alors placé dans une bonne position de rétention.

Dans un exemple présenté figure 5, la carte électronique 2 est retenue par le moyen de fixation 3 présenté sur une paroi du boîtier 1. Le dispositif de fixation 3 comporte dans cet exemple, une première languette protubérante 26 et une deuxième languette protubérante 27. Les deux languettes 26 et 27 sont préférentiellement parallèles l'une à l'autre. De plus, ces languettes 26 et 27 sont préférentiellement disposées parallèlement au fond 8. Dans cet exemple, la deuxième languette 27 est légèrement moins protubérante que la première languette 26. En effet, dans cet exemple la première languette 26 est disposée à une hauteur H1 par rapport au fond 8, alors que la deuxième languette 27 est disposée à une hauteur H2 par rapport à ce même fond 8 de telle sorte que la hauteur H2 est supérieure à la hauteur H1. La languette protubérante 26 a la particularité de présenter un rebord 28 redressé. Ce rebord 28 est tel qu'il ménage une faible ouverture 29 entre le rebord 28 et la languette protubérante 27. Cette ouverture 29 permet l'introduction de la carte 2 de manière oblique. On introduit la carte 2 à l'intérieur de la cavité formée par les languettes inférieure et supérieure 26 et 27 jusqu'à ce que la carte 2 vienne en butée contre la paroi du boîtier 1, ou la languette inférieure 26. Ensuite, la carte 2 est descendue selon une direction 30. Lors de cette descente selon la direction 30, la carte 2 vient au contact du bombement 13 du verrou élastique 6. L'enfoncement de la carte électronique 2 exerce une contrainte sur la lame 11 qui aboutit à la flexion selon la direction 31 du pied de fixation 16. En effet, la lame 11 est légèrement fléchie de manière à pouvoir proposer un enfoncement de la carte 2 jusqu'à ce que cette carte 2 soit retenue par le décrochement 14. Le décrochement 14 est situé à une hauteur H3, telle que cette hauteur H3 est comprise entre la hauteur H1 et la hauteur H2. Ainsi la carte est disposée de manière quasi parallèle au fond 8. Dans l'exemple présenté figure 5, le verrou élastique 6 comporte un palier 32 pour retenir une descente plus importante de la carte 2 sous la contrainte exercée dans la direction 30. Dans cet exemple, le verrou élastique 6 forme une encoche.

Dans un exemple particulier de réalisation de la pièce 7, présenté figure 2 on peut prévoir une pièce 7 munie de plusieurs lames telles que 11. En effet, la pièce 7 peut comporter une deuxième lame 33. Cette lame 33 est juxtaposée à la lame 11. Dans un exemple, cette lame 33 peut orienter son verrou élastique 34 dans une direction opposée à la direction du verrou 6 de la lame 11. Alors les verrous 6 et 34 sont disposés dans deux directions opposées. Ainsi, le deuxième verrou 34 permet de maintenir une carte telle que 2 disposée dans un autre emplacement du boîtier 1. Par ailleurs, le verrou 34 est à une hauteur H4 par rapport au support 10, soit quasiment par rapport au fond 8. Cette hauteur H4 est supérieure à une hauteur H5 du verrou 6 de la lame 11. Alors cette pièce 7 permet de retenir des cartes, telles que 2 à des hauteurs différentes à l'intérieur du boîtier 1.

Dans l'exemple présenté figure 5, le premier moyen de fixation 3 est constitué par les deux languettes protubérantes 26 et 27. Dans une variante, on peut prévoir que la carte électronique 2 soit retenu par un deuxième verrou élastique tel que le verrou élastique 6 présenté sur une deuxième pièce telle que 7. Ainsi dans cet exemple, la carte 2 serait retenu entre deux pièces telles que 7 présentant chacune un verrou élastique tel que 6 à une même hauteur par rapport au fond 8. Dans ce cas, les pièces telles que 7 comportent chacune un palier tel que 32.

Etant donné que les moyens de fixation d'une carte lui sont spécifiques, si l'on prévoit sur une pièce telle que 7 différents moyens de fixation juxtaposés, on peut prévoir d'empiler plusieurs cartes les unes au-dessus des autres sans pour autant qu'il y ait une distance minimale intercarte à respecter. On peut ainsi penser rapprocher les cartes telles que 2 au maximum. En effet, les moyens de fixation des différentes plaques sont indépendantes les unes des autres. Ainsi, dans l'exemple présenté figure 2, la pièce 7 présente deux lames telles que 11 juxtaposées par exemple la lame 11 et une lame 35 telles que les lames 11 et 35 sont orientées dans la même direction. Mais telle que les hauteurs des verrous telles que 6 de chacune de ces lames sont distinctes.

## Revendications

1. Boîtier (1) avec un dispositif de fixation d'une carte électronique (2), le boîtier (1) comportant un moyen de fixation (3) pour retenir un premier bord (4) de la carte électronique (2), et comportant une pièce (7) munie d'un verrou élastique (6) pour retenir un deuxième bord (5) de cette carte électronique (2), **caractérisé en ce que** la pièce (7) comporte un support (10) et une patte (19) parallèle au support (10), et **en ce que** le boîtier (1) comporte un fond (8) muni d'une ouverture (9) apte à recevoir cette patte (7) dans une position d'insertion, le fond (8) étant muni d'un moyen pour bloquer la pièce (7) dans une position de rétention après insertion et rotation (22) de la pièce (7).

2. Boîtier selon la revendication 1 **caractérisé en ce que** le fond (8) du boîtier (1) comporte un décrochement en surélévation (23) sur la face supérieure (21) du fond (8) pour retenir le support (10) dans la position de rétention.

3. Boîtier selon l'une des revendications 1 à 2 **caractérisé en ce que** le fond (8) du boîtier (1) comporte une butée (24) sur la face inférieure (20) du fond (8), la butée (24) coopérant avec la patte (7), pour la bloquer dans la position de rétention.

4. Boîtier selon l'une des revendications 1 à 3 **caractérisé en ce que** la pièce (7) comporte une lame (11), la lame (11) étant orthogonale au support (10) et légèrement flexible par rapport à ce support (10), et telle que le verrou élastique (6) est présenté sur cette lame (11).

5. Boîtier selon l'une des revendications 1 à 4 **caractérisé en ce que** le verrou élastique (6) comporte une encoche.

6. Boîtier selon l'une des revendications 1 à 5 **caractérisé en ce que** le moyen de fixation (3) de la carte électronique (2) est un verrou élastique.

7. Boîtier selon l'une des revendications 1 à 6 **caractérisé en ce que** le boîtier (1) comporte deux languettes protubérantes (26, 27) d'une paroi du boîtier (1), tel qu'une première languette (26) est disposée à une première hauteur (H1) dans le boîtier (1), et tel qu'une deuxième languette (27) est disposée à une deuxième hauteur (H2) dans ce boîtier (1), afin que le verrou élastique (6) soit présenté à une troisième hauteur (H3) comprise entre la première hauteur (H1) et la deuxième hauteur (H2).

8. Boîtier selon l'une des revendications 1 à 7 **caractérisé en ce que** la pièce (7) comporte plusieurs lames (11, 33) juxtaposées avec des verrous élastiques (6, 34) à différentes hauteurs (H4, H5) pour pouvoir retenir plusieurs cartes électroniques à différentes hauteurs dans le boîtier (1), et/ou avec des verrous élastiques (6, 34) orientés dans différentes directions pour pouvoir retenir plusieurs cartes électroniques dans au moins deux directions à l'intérieur du boîtier (1).

9. Procédé de fixation d'une carte électronique (2) dans un boîtier (1) selon l'une des revendications 1 à 8 **caractérisé en ce qu'**il comporte les étapes suivantes :
- on insère de manière oblique un premier bord (4) de la carte électronique (2) dans un moyen de fixation (3) du boîtier (1);
- on abaisse un deuxième bord (5) de la carte électronique (2);
- on écarte légèrement un verrou élastique (6) présenté sur une lame (11) d'une pièce (7) montée dans le boîtier (1);
- on relâche le verrou élastique (6) de manière à retenir le deuxième bord (5) de la carte électronique (2).

10. Procédé selon la revendication 9 **caractérisé en ce que**, pour monter la pièce (7) dans le boîtier (1), il comporte les étapes suivantes :
- on insère une patte (17) de la pièce (7) dans une ouverture (9) d'un fond (8) du boîtier (1);
- on tourne la pièce (7) de manière à glisser un support (10) de cette pièce (7) sous un décrochement en surélévation (23) d'un premier côté (21) du fond (8), et de manière à bloquer la patte (17) par une butée (24) présentée sur un deuxième côté (20) du fond (8).

## Patentansprüche

1. Gehäuse (1) mit einer Vorrichtung zur Befestigung einer Elektronikkarte (2), wobei das Gehäuse (1) eine Befestigungseinrichtung (3) zum Festhalten eines ersten Rands (4) der Elektronikkarte (2) und ein Bauteil (7) aufweist, das mit einem elastischen Riegel (6) versehen ist, um einen zweiten Rand (5) dieser Elektronikkarte (2) festzuhalten, **dadurch gekennzeichnet, daß** das Bauteil (7) einen Träger (10) und eine Lasche (19) parallel zum Träger (10) aufweist, und daß das Gehäuse (1) einen Boden (8) mit einer Öffnung (9) aufweist, die diese Lasche (7) in einer Einführstellung aufnehmen kann, wobei der Boden (8) mit einer Einrichtung versehen ist, um das Bauteil (7) nach der Einführung und Drehung (22) des Bauteils (7) in einer Befestigungsstellung zu blockieren.

2. Gehäuse nach Anspruch 1, **dadurch gekennzeichnet, daß** der Boden (8) des Gehäuses (1) auf einer Oberseite (21) des Bodens (8) einen hochstehenden Absatz (23) aufweist, um den Träger (10) in der Befestigungsstellung zurückzuhalten.

3. Gehäuse nach einem der Ansprüche 1 bis 2, **dadurch gekennzeichnet, daß** der Boden (8) des Gehäuses (1) auf einer Unterseite (20) des Bodens (8) einen Anschlag (24) aufweist, wobei der Anschlag (24) mit der Lasche (7) zusammenwirkt, um sie in der Befestigungsstellung zu blockieren.

4. Gehäuse nach einem der Ansprüche 1 bis 3, **dadurch gekennzeichnet, daß** das Bauteil (7) eine Lamelle (11) aufweist, wobei die Lamelle (11) senkrecht zum Träger (10) liegt und in bezug auf diesen Träger (10) leicht biegsam und so ausgebildet ist, daß der elastische Riegel (6) sich auf dieser Lamelle (11) befindet.

5. Gehäuse nach einem der Ansprüche 1 bis 4, **dadurch gekennzeichnet, daß** der elastische Riegel (16) eine Kerbe aufweist.

6. Gehäuse nach einem der Ansprüche 1 bis 5, **dadurch gekennzeichnet, daß** die Einrichtung (3) zur Befestigung der Elektronikkarte (2) ein elastischer Riegel ist.

7. Gehäuse nach einem der Ansprüche 1 bis 6, **dadurch gekennzeichnet, daß** das Gehäuse (1) zwei aus einer Wand des Gehäuses (1) vorstehende Zungen (26, 27) aufweist, derart, daß eine erste Zunge (26) sich auf einer ersten Höhe (H1) im Gehäuse befindet und eine zweite Zunge (27) sich auf einer zweiten Höhe (H2) in diesem Gehäuse (1) befindet, damit der elastische Riegel (6) sich auf einer dritten Höhe (H3) zwischen der ersten Höhe (H1) und der zweiten Höhe (H2) befindet.

8. Gehäuse nach einem der Ansprüche 1 bis 7, **dadurch gekennzeichnet, daß** das Bauteil (7) mehrere nebeneinander angeordnete Lamellen (11, 33) aufweist, die mit in verschiedenen Höhen (H4, H5) angeordneten elastischen Riegeln (6, 34) versehen sind, um mehrere Elektronikkarten auf unterschiedlichen Höhen im Gehäuse (1) halten zu können, und/oder mit in verschiedenen Richtungen ausgerichteten Riegeln (6, 34) versehen sind, um mehrere Elektronikkarten in mindestens zwei Richtungen innerhalb des Gehäuses (1) festhalten zu können.

9. Verfahren zur Befestigung einer Elektronikkarte (2) in einem Gehäuse (1) nach einem der Ansprüche 1 bis 8, **dadurch gekennzeichnet, daß** es die folgenden Schritte aufweist:
- man fügt einen ersten Rand (4) der Elektronikkarte (2) schräg in eine Befestigungseinrichtung (3) des Gehäuses (1) ein;
- man drückt einen zweiten Rand (5) der Elektronikkarte (2) nach unten;
- man spreizt einen elastischen Riegel (6) auf einer Lamelle (11) eines in das Gehäuse (1) montierten Bauteils (7) leicht ab;
- man läßt den elastischen Riegel (6) los, um den zweiten Rand (5) der Elektronikkarte (2) festzuhalten.

10. Verfahren nach Anspruch 9, **dadurch gekennzeichnet, daß** es zum Einbau des Bauteils (7) in das Gehäuse (1) die folgenden Schritte aufweist:
- man fügt eine Lasche (17) des Bauteils (7) in eine Öffnung (9) eines Bodens (8) des Gehäuses (1) ein;
- man dreht das Bauteil (7) so, daß ein Träger (10) dieses Bauteils (7) unter einen hochstehenden Absatz (23) einer ersten Seite (21) des Bodens (8) gleitet, und so, daß die Lasche (17) von einem auf einer zweiten Seite (20) des Bodens (8) vorhandenen Anschlag (24) blockiert wird.

## Claims

1. Housing (1) with a device for fixing an electronic circuit board (2), the housing (1) comprising a fixing means (3) for retaining a first edge (4) of the electronic circuit board (2), and comprising a part (7) provided with an elastic latch (6) for retaining a second edge (5) of this electronic circuit board (2), **characterised in that** the part (7) comprises a support (10) and a foot (19) parallel to the support (10), and **in that** the housing (1) comprises a bottom (8) provided with an opening (9) suitable for receiving this foot (7) in an insertion position, the bottom (8) being provided with a means for locking the part (7) in a retention position after insertion and rotation (22) of the part (7).

2. Housing according to claim 1, **characterised in that** the bottom (8) of the housing (1) comprises a raised catch (23) on an upper face (21) of the bottom (8) for retaining the support (10) in the retention position.

3. Housing according to one of claims 1 to 2, **characterised in that** the bottom (8) of the housing (1) comprises a stop (24) on a lower face (20) of the bottom (8), the stop (24) co-operating with the foot (7), to lock it in the retention position.

4. Housing according to one of claims 1 to 3, **characterised in that** the part (7) comprises a blade (11), the blade (11) being at right angles to the support (10) and slightly flexible in relation to this support (10), and such that the elastic latch (6) is presented on this blade (11).

5. Housing according to one of claims 1 to 4, **characterised in that** the elastic latch (16) comprises a notch.

6. Housing according to one of claims 1 to 5, **characterised in that** the fixing means (3) for the electronic circuit board (2) is an elastic latch.

7. Housing according to one of claims 1 to 6, **characterised in that** the housing (1) comprises two protruding tabs (26, 27) extending from a wall of the housing (1), such that a first tab (26) is disposed at a first height (H1) in the housing (1), and such that a second tab (27) is disposed at a second height (H2) in this housing (1), so that the elastic latch (6) is presented at a third height (H3) lying between the first height (H1) and the second height (H2).

8. Housing according to one of claims 1 to 7, **characterised in that** the part (7) comprises a plurality of juxtaposed blades (11, 33) with elastic latches (6, 34) at different heights (H4, H5) to be able to retain a plurality of electronic circuit boards at different heights in the housing (1), and/or with elastic latches (6, 34) oriented in different directions to be able to retain a plurality of electronic circuit boards in at least two directions inside the housing (1).

9. Methed for fixing an electronic circuit board (2) in a housing (1) according to one of claims 1 to 8, **characterised in that** it comprises the following steps:
- a first edge (4) of the electronic circuit board (2) is inserted obliquely in a fixing means (3) of the housing (1) ;
- a second edge (5) of the electronic circuit board (2) is lowered;
- an elastic latch (6) presented on a blade (11) of a part (7) mounted in the housing (1) is opened slightly;
- the elastic latch (6) is released so as to retain the second edge (5) of the electronic circuit board (2).

10. Method according to claim 9, **characterised in that** in order to mount the part (7) in the housing (1), it comprises the following steps:
- a foot (17) of the part (7) is inserted in an opening (9) in a bottom (8) of the housing (1);
- the part (7) is turned so as to slide a support (10) of this part (7) under a raised catch (23) on a first side (21) of the bottom (8), and so as to lock the foot (17) by a stop (24) presented on a second side (20) of the bottom (8).
